# EUROPÄISCHE PATENTSCHRIFT

(11) **EP 3 029 803 B1**
(45) Veröffentlichungstag und Bekanntmachung des Hinweises auf die Patenterteilung: **13.06.2018**
(21) Anmeldenummer: 14195843.9
(22) Anmeldetag: 02.12.2014
(51) Int. Cl.: H02J 7/14, B61D 43/00, B60L 1/14, H02K 35/00, F03G 7/08, H02N 2/18, B60Q 1/56, B60G 17/019, B60Q 1/32, H01L 41/113, H02K 35/02, H02K 35/04, H02N 1/08, H02J 7/34, H02K 7/18, B60Q 3/64, B60Q 3/217, B60Q 3/80

(54) **Stromerzeugende Vorrichtung für ein Fahrzeug**
Electric generating device for a vehicle
Dispositif produisant du courant pour un véhicule

(43) Veröffentlichungstag der Anmeldung: 08.06.2016
(60) Teilanmeldung: 18158928.4
(73) Patentinhaber: WEIDPLAS GmbH, 8700 Küsnacht (CH)
(72) Erfinder: Buehrle, Sascha, 94301 Palo Alto (US); Bodmer, Urs, B1801 Xiamen, Fujian (CN)
(74) Vertreter: Rutz, Andrea

(56) Entgegenhaltungen:
- EP-A1- 2 536 020
- US-A1- 2008 129 147
- US-A1- 2010 102 673
- US-A1- 2013 328 416
- US-B2- 7 977 852

## Beschreibung

### TECHNISCHES GEBIET

Die vorliegende Erfindung betrifft eine stromerzeugende Vorrichtung für ein Fahrzeug. Bei der Vorrichtung kann es sich um eine hinterleuchtbare Zierleiste, wie zum Beispiel eine Einstiegsleiste, handeln. Die Erfindung betrifft ausserdem ein Fahrzeug mit einer derartigen Vorrichtung sowie ein Verfahren zur Erzeugung von elektrischer Energie in einem Fahrzeug.

### STAND DER TECHNIK

In Fahrzeugen und insbesondere im Automobilbereich kommt oft eine Vielzahl von unterschiedlichen elektrisch betriebenen Einrichtungen zum Einsatz, wie zum Beispiel ein Autoradio, eine Freisprechanlage, ein Klimagerät etc. Diese Einrichtungen beziehen ihre für den Betrieb benötigte Energie üblicherweise vom elektrischen System des Fahrzeugs, welches meist einen Energiespeicher in Form von einem Akkumulator aufweist, der seinerseits während der Fahrt vom Motor aufgeladen wird.

Neben diesen Einrichtungen mit einem verhältnismässig hohen Energiebedarf werden in Fahrzeugen aber immer häufiger auch elektrisch betriebene Einrichtungen verwendet, welche einen vergleichsweise geringen Bedarf an elektrischer Energie haben. Bei einer derartigen Einrichtung kann es sich beispielsweise um eine hinterleuchtbare Zierleiste handeln, welche zum Beispiel als Einstiegsleiste unmittelbar unterhalb der Fahrertüre angeordnet sein kann, um dem Fahrer beim Einsteigen zum Beispiel die Automarke oder einen Warnhinweis anzuzeigen. Der für die Hinterleuchtung benötigte Energiebedarf ist bei derartigen Zierleisten meist sehr gering.

Auch wenn der Energiebedarf bei derartigen elektrisch betriebenen Einrichtungen oft nur gering ist, muss üblicherweise eine aufwändige Verkabelung vorgesehen werden, um die Einrichtung an das elektrische System des Fahrzeugs anzuschliessen. Oft müssen zusätzliche Anschlusskabel im Fahrzeug verlegt werden, und es müssen zusätzliche Bohrungen in der Fahrzeugkarosserie vorgesehen werden, um diese Anschlusskabel hindurchzuführen. Gerade im Falle von Zierleisten und insbesondere bei Einstiegsleisten besteht zudem die Gefahr, dass im Bereich einer Bohrung, durch welche das Anschlusskabel hindurchgeführt wird, Feuchtigkeit in das Fahrzeug eindringt. Zudem sind die elektrischen Einrichtungen und insbesondere Einstiegsleisten oft äusseren mechanischen Einflüssen ausgesetzt, welche dazu führen können, dass das daran angeschlossene Anschlusskabel, vor allem wenn es durch eine Karosseriebohrung hindurch geführt ist, abknickt oder eingeklemmt wird. Aufgrund der aufwändigen Verkabelung ist ein Nachrüsten von Fahrzeugen mit derartigen elektrisch betriebenen Einrichtungen ausserdem kostspielig.

Alternativ zu einem Anschluss an das elektrische System des Fahrzeugs werden in elektrischen Einrichtungen von Fahrzeugen oft Batterien bzw. wieder aufladbare Akkumulatoren verwendet. Der Nachteil von Batterien bzw. Akkumulatoren besteht jedoch darin, dass diese nach einer gewissen Zeit ausgewechselt bzw. wieder aufgeladen werden müssen, was für den Benutzer einen gewissen Aufwand bedeutet. Ausserdem sind die Batterien bzw. Akkumulatoren Temperaturschwankungen ausgesetzt, wodurch deren Funktion und Lebensdauer je nach Anwendungsfall und Einsatzgebiet nicht ausreichend gewährleistet werden kann.

Eine Einstiegsleiste für ein Kraftfahrzeug, welche mit Batterien in Form von Knopfzellen betrieben wird, ist in der DE 10 2011 112 808 A1 offenbart.

In der US 2007/0258262 A1 und der US 5,578,877 wird jeweils ein autarkes Energieversorgungssystem für eine elektrische Vorrichtung in einem Fahrzeug vorgeschlagen. Diese Systeme beruhen jeweils auf einem Schwingungssystem mit einer beweglich angeordneten Schwungmasse sowie einer Induktionseinheit zur induktiven Umwandlung von Bewegungsenergie der Schwungmasse in elektrische Energie. Durch die im Betrieb des Fahrzeugs entstehenden Vibrationen wird die Schwungmasse in Bewegung gesetzt und Strom für die jeweilige elektrische Vorrichtung generiert. Je nach Fahrzeugtyp, Ladezustand, Strassenbelag etc. ist die Energieausbeute von derartigen autarken Energieversorgungssystemen aber oft nicht zufriedenstellend.

Die US 2010/0102673 A1, die EP 2 536 020 A1 und die US 2008/0129147 A1 offenbaren verschiedene Vorrichtungen zur induktiven Erzeugung von elektrischer Energie mittels einer Schwungmasse. Dabei ist die Resonanzfrequenz des Schwingungssystems jeweils an die einwirkende Vibrationsfrequenz anpassbar.

### DARSTELLUNG DER ERFINDUNG

Es ist also eine Aufgabe der vorliegenden Erfindung, die Energieausbeute bei einer stromerzeugenden Vorrichtung für ein Fahrzeug zu verbessern. Die stromerzeugende Vorrichtung soll zudem möglichst einfach und bei unterschiedlichen Fahrzeugen und Fahrzeugtypen eingesetzt werden können. Zur Lösung dieser Aufgabe wird ein Fahrzeug mit einer stromerzeugenden Vorrichtung vorgeschlagen, wie es in Anspruch 1 angegeben ist. Vorteilhafte Ausgestaltungen der Erfindung sind in den abhängigen Ansprüchen angegeben.

Die vorliegende Erfindung stellt also ein Fahrzeug, insbesondere ein Kraftfahrzeug, mit einer stromerzeugenden Vorrichtung zur Verfügung, die stromerzeugende Vorrichtung aufweisend
ein Schwingungssystem mit einer beweglich angeordneten Schwungmasse; sowie
eine Induktionseinheit zur induktiven Umwandlung von Bewegungsenergie der Schwungmasse in elektrische Energie.
Die stromerzeugende Vorrichtung weist zudem zumindest einen Sensor, insbesondere einen Beschleunigungssensor, zur Ermittlung einer Vibrationsfrequenz des Fahrzeugs sowie eine Steuereinheit zur Anpassung der Resonanzfrequenz des Schwingungssystems an eine ermittelte Vibrationsfrequenz des Fahrzeugs auf.

Mittels des Sensors kann die Steuereinheit bei Bedarf eine Vibrationsfrequenz des Fahrzeugs ermitteln und die Resonanzfrequenz des Schwingungssystems entsprechend an eine ermittelte Vibrationsfrequenz anpassen. Somit ermittelt die Steuereinheit unter Verwendung von vom Sensor aufgezeichneten Daten wenigstens eine Vibrationsfrequenz des Fahrzeugs. Von der wenigstens einen ermittelten Vibrationsfrequenz wird wenigstens eine Frequenz ausgewählt und die Frequenz des Schwingungssystems, insbesondere der Schwungmasse, in Resonanz mit der ausgewählten Frequenz gebracht. Die in Resonanz mit der ausgewählten Frequenz gebrachte Frequenz des Schwingungssystems, insbesondere der Schwungmasse, wird im Rahmen der Erfindung als Resonanzfrequenz bezeichnet. Auf diese Weise kann sichergestellt werden, dass das Schwingungssystem optimal an die aktuellen Gegebenheiten angepasst ist, d.h. optimal angepasst ist an die aktuell vorherrschenden Vibrationen des Fahrzeugs, welche beispielsweise abhängig sind vom Fahrzeugtyp, der Bereifung, dem Ladezustand oder dem Strassenzustand (Schnee, Asphalt, Kiesweg etc.). Dadurch, dass das Schwingungssystem jederzeit in Resonanz mit den Vibrationen des Fahrzeugs gebracht werden kann, werden die Vibrationen des Fahrzeugs optimal in eine Schwingungsbewegung der Schwungmasse und somit die Bewegungsenergie der schwingenden Schwungmasse mittels Induktion in elektrische Energie umgewandelt. Aufgrund dieser bevorzugt automatischen Anpassung der Resonanzfrequenz an eine Vibrationsfrequenz des Fahrzeugs kann dieselbe stromerzeugende Vorrichtung somit ohne weitere Vorkehrungen bei unterschiedlichsten Fahrzeugen eingesetzt werden. Die stromerzeugende Vorrichtung kann damit für unterschiedliche Fahrzeuge identisch hergestellt werden, wodurch der Aufwand und die Herstellungskosten wesentlich verringert werden. Die Vorrichtung eignet sich zudem insbesondere sehr gut zum Nachrüsten, da bei der Montage am Fahrzeug in der Regel keine manuellen Anpassungen des Schwingungssystems vorgenommen werden müssen. Aufgrund des Aufbaus des Schwingungssystems der erfindungsgemässen Vorrichtung kann die stromerzeugende Vorrichtung vergleichsweise dünn ausgebildet werden und beansprucht somit vergleichsweise wenig Bauraum im Fahrzeug.

Für die Ermittlung einer Vibrationsfrequenz des Fahrzeugs kann in der Steuereinheit wenigstens ein Frequenzspektrum der vom Sensor ermittelten Daten, insbesondere Beschleunigungsdaten, berechnet und eine Frequenz aus dem wenigstens einen Frequenzspektrum ausgewählt werden, welche bevorzugt eine maximale Energieausbeute erlaubt. Die Energieausbeute ist insbesondere abhängig von der Höhe der Frequenz sowie von der Amplitude der Vibration. Das Schwingungssystem kann dann entsprechend derart von der Steuereinheit eingestellt werden, dass die Resonanzfrequenz an die aus dem wenigstens einen Frequenzspektrum ausgewählte Frequenz angepasst ist, so dass die stromerzeugende Vorrichtung bevorzugt eine maximale Energie aufnehmen kann. Bei der Steuereinheit handelt es sich in der Regel um ein Elektronikbauteil, welches vorteilhaft eine Rechnereinheit, wie insbesondere eine CPU, aufweist.

Die stromerzeugende Vorrichtung weist vorteilhaft zumindest zwei Schwingungssysteme mit jeweils einer Schwungmasse und einer Induktionseinheit auf. Die Schwingungssysteme können dann mit ihren Resonanzfrequenzen zum Beispiel an unterschiedliche typischerweise auftretende Vibrationsfrequenzen des Fahrzeugs angepasst werden. Die Schwingungssysteme können derart ausgebildet sein, dass ihre Schwungmassen in jeweils dieselbe Richtung bewegbar sind. Die Schwingungssysteme können aber auch derart ausgebildet sein, dass ihre Schwungmassen in unterschiedliche, insbesondere aufeinander im Wesentlichen senkrecht stehende, Richtungen bewegbar sind. Die Ausbildung der wenigstens zwei Schwingungssysteme derart, dass ihre Schwungmassen in unterschiedliche Richtungen bewegbar sind, bietet den Vorteil, dass die Vibrationen des Fahrzeugs unabhängig von ihrer Richtung in eine Bewegung von zumindest einer Schwungmasse und somit in elektrische Energie umgewandelt werden können.

Beim Fahrzeug kann es sich insbesondere um ein Strassenfahrzeug, wie ein Kraftfahrzeug, einen Lastkraftwagen oder ein Motorrad, handeln. Es kann aber auch ein schienengebundenes Fahrzeug oder ein Flugzeug sein.

Vorteilhaft ist der Sensor in oder unmittelbar an der stromerzeugenden Vorrichtung angeordnet, vorteilhafter in der stromerzeugenden Vorrichtung angeordnet. Die Anordnung des Sensors in oder unmittelbar an der stromerzeugenden Vorrichtung bietet den Vorteil, dass die Vibrationen des Fahrzeugs, welche auf die stromerzeugende Vorrichtung, insbesondere auf dessen Schwingungseinheit, übertragen werden und somit potentiell vom Schwingungssystem in elektrische Energie umgewandelt werden können, auch vom Sensor wahrgenommen werden können. Somit nimmt der Sensor die von der stromerzeugenden Vorrichtung aufgenommenen Vibrationen des Fahrzeugs, welche potentiell in elektrische Energie umwandelbar sind, unmittelbar wahr, so dass die Steuereinheit die Resonanzfrequenz des Schwingungssystems, bzw. dessen Schwungmasse, an die Frequenzen der in elektrische Energie umwandelbaren Vibrationen des Fahrzeugs anpassen kann. Somit ist die Art und Weise, bzw. wie oder wie fest die stromerzeugende Vorrichtung an dem Fahrzeug befestigt ist nicht so kritisch. Selbstverständlich kann der Sensor auch ausserhalb der stromerzeugenden Vorrichtung im oder unmittelbar am Fahrzeug angeordnet sein und die ermittelten Frequenzdaten der Vibrationen des Fahrzeuges an die stromerzeugende Vorrichtung, beispielsweise kabellos bzw. "wireless", übertragen. In diesem Fall wird der Sensor vom elektrischen System des Fahrzeugs betrieben.

Beim Sensor handelt es sich bevorzugt um einen Beschleunigungssensor. Dem Fachmann sind für diese Anwendung geeignete Beschleunigungssensoren hinlänglich bekannt. Die Verwendung von einem oder mehreren Vibrationsplättchen im Sensor ist ebenfalls möglich.

Die Schwungmasse, welche vorteilhaft einen Permanentmagneten aufweist, ist üblicherweise derart angeordnet, dass sie relativ zu einer Ruhelage zum Beispiel verschiebbar oder rotierbar ist. Bei der Verschiebung führt die Schwungmasse bevorzugt eine Translationsbewegung, bevorzugter eine Linearbewegung aus. Das Schwingungssystem weist in der Regel zumindest ein Rückstellelement auf, um bei einer Bewegung der Schwungmasse aus ihrer Ruhelage heraus auf die Schwungmasse eine Rückstellkraft in Richtung der Ruhelage auszuüben.

Das Schwingungssystem ist, insbesondere was im Schwingungszustand die Bewegungsrichtung der Schwungmasse angeht, im Wesentlichen parallel, bevorzugt koaxial, zur Längsachse des Fahrzeugs angeordnet. Somit schwingt das Schwingungssystem, insbesondere dessen Schwungmasse, im Wesentlichen parallel, bevorzugt koaxial, zur Längsachse des Fahrzeugs und somit in Fahrtrichtung des Fahrzeugs. Dies bietet den Vorteil, dass die Energieausbeute der stromerzeugenden Vorrichtung bei Fahrzeugen, insbesondere bei Kraftfahrzeugen, besonders hoch ist.

Vorteilhaft wird die Resonanzfrequenz wenigstens an eine Frequenz aus dem Frequenzspektrum der Vibrationen des Fahrzeugs in x-Richtung ausgewählt, wobei die x-Richtung definiert ist als die Richtung koaxial zur Längsachse des Fahrzeugs, wobei die y-Achse definiert ist als die Richtung in einem Winkel von 90° quer zur x-Achse und wobei die z-Achse definiert ist als die Richtung in einem Winkel von 90° zur x-Achse und zur y-Achse. Das Frequenzspektrum der Vibrationen des Fahrzeugs in x-Richtung wird bevorzugt mittels eines Beschleunigungssensors ermittelt. Bei Fahrzeugen, insbesondere bei Kraftfahrzeugen, weisen die Vibrationen in x-Richtung vergleichsweise besonders hohe Frequenzen sowie Amplituden auf und somit führt die Anpassung der Resonanzfrequenz an eine Frequenz in x-Richtung zu einer besonders hohen Energieausbeute durch die stromerzeugende Vorrichtung. Eine besonders hohe Energieausbeute ergibt sich insbesondere, falls die stromerzeugende Vorrichtung, insbesondere deren Schwungmasse, parallel bzw. koaxial zur Längsachse des Fahrzeugs, insbesondere eines Kraftfahrzeugs, angeordnet ist. Selbstverständlich kann die Resonanzfrequenz an eine Frequenz angepasst werden, welche im Frequenzspektrum der Vibrationen des Fahrzeugs in x-Richtung sowie im Frequenzspektrum der Vibrationen des Fahrzeugs in y-Richtung und / oder z-Richtung vorkommt. Falls zusätzlich zum Frequenzspektrum in x-Richtung das Frequenzspektrum in y-Richtung und / oder z-Richtung berücksichtigt wird, so weist die stromerzeugende Vorrichtung bevorzugt ein Schwingungssystem, insbesondere eine Schwungmasse auf, welche in die zusätzlich zu berücksichtigende(n) Richtung(en) schwingen kann.

Vorteilhaft sind zwei Rückstellelemente vorgesehen, zwischen denen die Schwungmasse in einer Schwingungsbewegung hin- und her bewegbar ist. Als Rückstellelement kann zum Beispiel eine Feder, wie insbesondere eine Schrauben- oder Torsionsfeder dienen, um bei einer Bewegung der Schwungmasse aus ihrer Ruhelage heraus auf diese eine Rückstellkraft in Richtung der Ruhelage auszuüben. Bei der Rückstellkraft handelt es sich dann zumindest teilweise, insbesondere im Wesentlichen vollständig, um eine Federkraft. Möglich ist aber auch die Verwendung von einem oder mehreren Magneten, um als Rückstellelement(e) bei einer Bewegung der Schwungmasse aus ihrer Ruhelage heraus eine Rückstellkraft in Richtung der Ruhelage auszuüben. Der oder die Magnete können als Permanent- oder Elektromagnete ausgebildet sein. Bei der Rückstellkraft handelt es sich dann zumindest teilweise, insbesondere im Wesentlichen vollständig, um eine Magnetkraft.

Vorzugsweise weist die Induktionseinheit zumindest eine Induktionsspule mit einer Vielzahl von Windungen auf. Eine Bewegung der Schwungmasse erzeugt aufgrund von elektromagnetischer Induktion in der Induktionsspule einen elektrischen Strom, wodurch die Vorrichtung für eine autarke Energieversorgung geeignet ist. Die Induktionsspule ist vorteilhaft derart angeordnet, dass sie die Schwungmasse zumindest teilweise umgibt, wenn diese eine Schwingungsbewegung ausführt. Bevorzugt ist wenigstens eine Windung der Induktionsspule zur Anpassung der Resonanzfrequenz des Schwingungssystems zu- bzw. abschaltbar. Die einzelnen Windungen sind somit bevorzugt jeweils einzeln zu- bzw. abschaltbar. Auf diese Weise ist basiert auf der Lenzschen Regel eine besonders einfache Anpassung der Resonanzfrequenz mittels der Steuereinheit möglich. Alternativ könnte die Resonanzfrequenz des Schwingungssystems zum Beispiel auch dadurch angepasst werden, dass die Rückstellelemente bzgl. ihrer Lage relativ zur Schwungmasse verschoben werden, oder dass die auf die Schwungmasse wirkende Rückstellkraft verändert wird, was besonders einfach ist, wenn ein Elektromagnet als Rückstellelement verwendet wird.

Die stromerzeugende Vorrichtung ist vorteilhaft insgesamt kompakt ausgestaltet und weist bevorzugt ein Gehäuse mit einem Innenraum auf, innerhalb welchem das Schwingungssystem, die Induktionseinheit sowie der Sensor angeordnet sind. Das Gehäuse ist vorteilhaft nach aussen hin im Wesentlichen vollständig abgeschlossen, so dass der Innenraum von aussen her nicht ohne weiteres zugänglich ist.

Bevorzugt handelt es sich bei der stromerzeugenden Vorrichtung um eine hinterleuchtbare Zierleiste. Die hinterleuchtbare Zierleiste ist beispielsweise eine Interiorleiste, wie beispielsweise eine Einstiegsleiste, oder eine Exteriorleiste. Eine Exteriorleiste ist bei Fahrzeugen umfassend eine Türe, eine Leiste, welche bei geschlossener Tür von ausserhalb des Fahrzeugs sichtbar ist. Die stromerzeugende Vorrichtung ist bevorzugt an einem nicht bewegbaren Bestandteil des Fahrzeugs, wie beispielsweise der Karosserie, befestigt. Die Einstiegsleiste ist bevorzugt an einer Türschwelle befestigt, kann aber auch im Bereich des Kofferraumes befestigt sein. Das Schwingungssystem, die Induktionseinheit und der Sensor sowie zumindest ein Leuchtelement, wie insbesondere eine LED, sind bevorzugt in einem Innenraum der Zierleiste angeordnet. Der in der Vorrichtung erzeugte elektrische Strom wird in diesem Fall also zur autarken Energieversorgung der Vorrichtung und insbesondere des Leuchtelements verwendet. Bevorzugt ist der Innenraum nach aussen hin von einer Abdeckung abgedeckt, welche vom Leuchtelement durchleuchtbar ist und hierzu bevorzugt hinterleuchtbare Durchbrüche aufweist. Zwischen dem Leuchtelement und den Durchbrüchen kann insbesondere ein vorteilhaft als Diffusor ausgebildeter Lichtleiter angeordnet sein, um das vom Leuchtelement ausgestrahlte Licht zur Abdeckung, insbesondere zu den Durchbrüchen der Abdeckung, hin zu leiten. Bevorzugt weist die Zierleiste, insbesondere die Einstiegsleiste, eine Dicke von 5 Millimeter oder kleiner auf. Die stromerzeugende Vorrichtung kann einen Lichtsensor aufweisen, um den Öffnungszustand einer Fahrzeugtüre zu detektieren und in Abhängigkeit vom detektierten Öffnungszustand der Fahrzeugtüre das Leuchtelement ein- bzw. auszuschalten.

Vorteilhaft liegt die Resonanzfrequenz des Schwingungssystems im Bereich von 15 bis 80 Hz, insbesondere im Bereich von 25 bis 45 Hz. Das Schwingungssystem ist dadurch an die in Fahrzeugen, insbesondere Kraftfahrzeugen, üblicherweise auftretenden Frequenzen der Vibrationen angepasst. Bevorzugt ist die Resonanzfrequenz des Schwingungssystems innerhalb dieses Bereiches an die tatsächlich auftretende Vibrationsfrequenz einstellbar. Die Vibrationsfrequenzen bewegen sich bei Fahrzeugen, insbesondere bei Kraftfahrzeugen, beim Betrieb deren Motors im Stillstand oder in Fahrt, in einem Bereich von üblicherweise 15 bis 80 Hz, insbesondere 25 bis 45 Hz. Diese Vibrationsfrequenzen des Fahrzeugs, insbesondere Kraftfahrzeugs, werden bevorzugt mit einem Beschleunigungssensor gemessen.

Die stromerzeugende Vorrichtung weist zudem vorteilhaft einen Energiespeicher zur Speicherung der von der Induktionseinheit erzeugten elektrischen Energie auf. Die während der Fahrt des Fahrzeugs erzeugte Energie kann dadurch auch nach einem Fahrzeugstillstand noch zur Verfügung stehen. Beim Energiespeicher kann es sich um einen wieder aufladbaren Akkumulator handeln. Vorteilhaft wird jedoch ein Kondensator-Speicher als Energiespeicher verwendet, da dieser durch Temperaturschwankungen weniger beeinflusst wird. Zudem ist bei Verwendung eines Kondensator-Speichers nicht zwingend eine Ladeelektronik notwendig. Besonders vorteilhaft hat sich die Verwendung eines UltraCaps erwiesen, da die erzeugte elektrische Energie dann bis zu zwei Wochen gespeichert bleibt, was für die meisten Anwendungen und insbesondere für die Hinterleuchtung von Zierleisten in der Regel ausreichend ist. Der Kondensator-Speicher kann besonders platzsparend untergebracht werden, wenn er eine flache Bauform hat.

Die Verbindung von Fahrzeug und stromerzeugender Vorrichtung bzw. die Befestigung der stromerzeugenden Vorrichtung am Fahrzeug ist bevorzugt derart, dass die Vibrationen optimal auf das Schwingungssystem der stromerzeugenden Vorrichtung übertragen werden können. Um die im Fahrzeug auftretenden Vibrationen optimal aufnehmen zu können, ist die stromerzeugende Vorrichtung vorteilhaft fest mit der Karosserie des Fahrzeugs verbunden, also am Grundgerüst des Fahrzeugs fixiert. Die stromerzeugende Vorrichtung ist vorteilhaft über ein Fahrzeugelement an der Fahrzeugkarosserie befestigt, d.h. mittelbar an der Fahrzeugkarosserie befestigt, oder vorteilhaft unmittelbar an der Fahrzeugkarosserie befestigt.

Die stromerzeugende Vorrichtung kann zum Beispiel mittels Schrauben oder mittels eines Haftklebers, wie insbesondere eines doppelseitigen Klebebandes, am Fahrzeug angebracht werden. Die Vorrichtung kann aber auch einen oder mehrere Magnete zur magnetischen Befestigung der Vorrichtung am Fahrzeug aufweisen.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine Schnittansicht durch eine teilweise dargestellte erste Ausführungsform einer erfindungsgemässen Vorrichtung in Form einer hinterleuchtbaren Zierleiste, mit vertikalen und horizontalen Feder-Masse-Schwingungssystemen;
- Fig. 2: eine Schnittansicht durch eine teilweise dargestellte zweite Ausführungsform einer erfindungsgemässen Vorrichtung in Form einer hinterleuchtbaren Zierleiste, mit zwei einseitig angeordneten Feder-Masse-Schwingungssystemen;
- Fig. 3: eine Schnittansicht durch eine teilweise dargestellte dritte Ausführungsform einer erfindungsgemässen Vorrichtung in Form einer hinterleuchtbaren Zierleiste, mit zwei beidseitig angeordneten Feder-Masse-Schwingungssystemen;
- Fig. 4: eine Schnittansicht durch eine teilweise dargestellte vierte Ausführungsform einer erfindungsgemässen Vorrichtung in Form einer hinterleuchtbaren Zierleiste, mit zwei beidseitig angeordneten Magnet-Magnet-Schwingungssystemen;
- Fig. 5: eine Schnittansicht durch eine teilweise dargestellte fünfte Ausführungsform einer erfindungsgemässen Vorrichtung in Form einer hinterleuchtbaren Zierleiste, mit zwei einseitig angeordneten Magnet-Magnet-Schwingungssystemen;
- Fig. 6: eine Schnittansicht durch eine teilweise dargestellte sechste Ausführungsform einer erfindungsgemässen Vorrichtung in Form einer hinterleuchtbaren Zierleiste, mit zwei beidseitig angeordneten rotatorischen Schwingungssystemen;
- Fig. 7: eine schematische Illustration der x-, y- und z-Achse eines Fahrzeugs;
- Fig. 8a: die x-Komponente der vom Beschleunigungssensor ermittelten Daten;
- Fig. 8b: die y-Komponente der vom Beschleunigungssensor ermittelten Daten;
- Fig. 8c: die z-Komponente der vom Beschleunigungssensor ermittelten Daten;
- Fig. 9a: das Frequenzspektrum der in der Fig. 8a gezeigten Daten;
- Fig. 9b: das Frequenzspektrum der in der Fig. 8b gezeigten Daten; sowie
- Fig. 9c: das Frequenzspektrum der in der Fig. 8c gezeigten Daten.

### BESCHREIBUNG BEVORZUGTER AUSFÜHRUNGSFORMEN

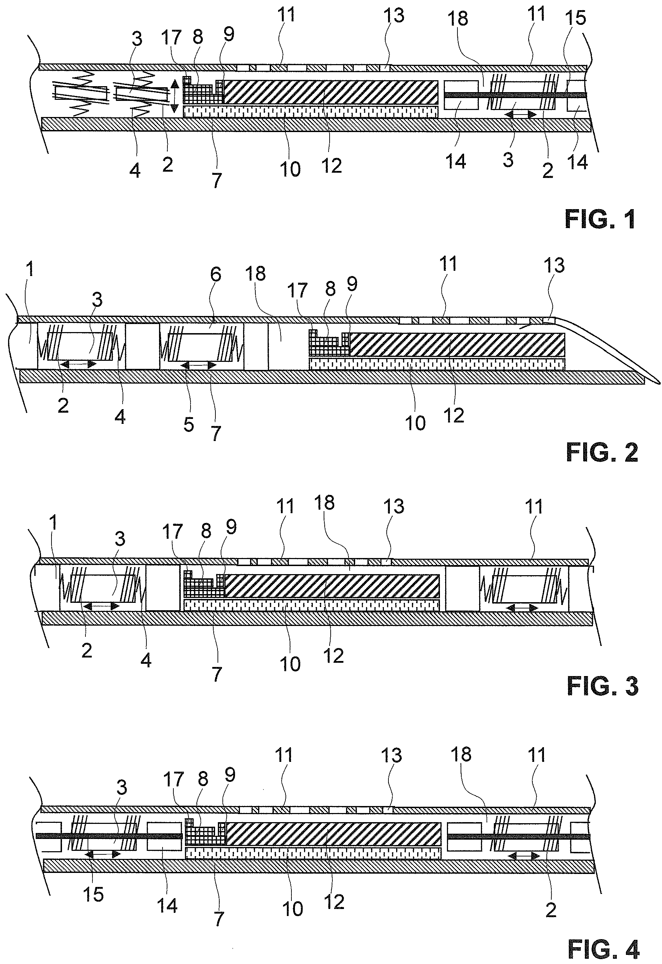

In den Figuren 1 bis 6 sind unterschiedliche Ausführungsformen von erfindungsgemässen stromerzeugenden Vorrichtungen für ein Fahrzeug gezeigt. Bei allen in den Figuren 1 bis 6 gezeigten Vorrichtungen handelt es sich um Zierleisten, welche bevorzugt als Einstiegsleiste im Fussbereich einer der Fahrzeugtüren angeordnet werden. Die Zierleisten können aber an einer beliebigen anderen Stelle innerhalb oder an einer Aussenseite des Fahrzeugs angeordnet werden, wie zum Beispiel im Bereich der Kofferraumtüre oder des Armaturenbretts. Bevorzugt weisen die Zierleisten eine durch die maximale Längenausdehnung der Zierleiste festgelegte Längsrichtung auf, welche sich parallel zur Längsachse 20 des Fahrzeugs erstreckt. Vorteilhaft ist die Zierleiste fest mit der Fahrzeugkarosserie verbunden. Sie kann insbesondere an einem fest mit der Fahrzeugkarosserie verbundenem Fahrzeugelement angeklebt oder mittels Magneten befestigt sein, d.h. mittelbar an der Fahrzeugkarosserie befestigt sein, oder unmittelbar an der Fahrzeugkarosserie befestigt sein.

In Bezug auf die in den Figuren 1 bis 6 gezeigten Ausführungsformen werden jeweils dieselben Bezugszeichen für gleiche oder ähnliche bzw. gleich oder ähnlich wirkende Elemente verwendet.

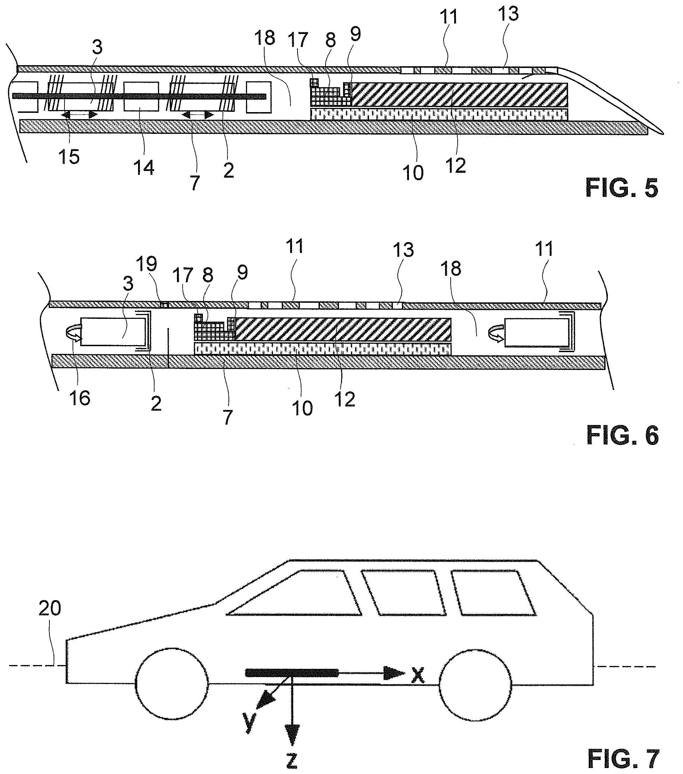

Die in der Figur 1 gezeigte Zierleiste weist ein Gehäuse mit einem Innenraum 18 auf. Der Innenraum 18 wird nach aussen hin von einer flächigen Abdeckung 11 sowie einer Trägerplatte 7 begrenzt, welche einen Teil des Gehäuses darstellen. Während die Abdeckung 11 mit ihrer dem Innenraum 18 abgewandten Seite die Sichtseite der Zierleiste bildet, bildet die Trägerplatte 7 mit ihrer dem Innenraum 18 abgewandten Seite die Rückseite der Zierleiste. Die Abdeckung 11 begrenzt den Innenraum 18 nicht nur nach vorne zur Sichtseite hin, sondern auch seitlich umlaufend (teilweise in den Figuren 2 und 5 erkennbar).

Innerhalb der Abdeckung 11 sind Durchbrüche 13 vorgesehen, welche jeweils eine Öffnung bilden, um das von einem im Innenraum angeordneten Leuchtelement 9 ausgestrahlte Licht nach aussen hin durchzulassen. Die Durchbrüche 13 können aufgrund ihrer äusseren Form zum Beispiel Buchstaben, Schriftzüge, Symbole oder ähnliches bilden. Um ein Eindringen von Feuchtigkeit und Schmutzpartikeln in den Innenraum 18 zu verhindern, sind die Durchbrüche 13 jeweils mit einem transluzentem Material, wie zum Beispiel Polymethylmethacrylat (PMMA), verschlossen.

Unmittelbar hinter den Durchbrüchen 13 ist im Innenraum 18 ein plattenförmiger Lichtleiter 12 angeordnet, welcher dazu dient, vom Leuchtelement 9 ausgestrahltes Licht zu den Durchbrüchen 13 hin zu leiten. Der Lichtleiter 12 kann insbesondere als ein Diffusor ausgestaltet sein, so dass die Durchbrüche 13 gleichmässig vom Licht, welches von einem einzigen Leuchtelement 9 ausgestrahlt wird, hinterleuchtet werden können. Beim Leuchtelement 9 handelt es sich bevorzugt um eine oder mehrere LEDs, welche seitlich zum Lichtleiter 12 angeordnet sind. Das Leuchtelement 9 und der Lichtleiter 12 sind im Wesentlichen auf derselben Höhe zwischen der Abdeckung 11 und der Trägerplatte 7 angeordnet. Die Zierleiste weist dadurch eine minimale Höhe auf.

Seitlich zum Lichtleiter 12 sind im Innenraum 18 mehrere Schwingungssysteme und Induktionseinheiten angeordnet. Die Schwingungssysteme weisen jeweils eine beweglich im Innenraum 18 angeordnete Schwungmasse in Form eines Magneten 3 sowie ein Rückstellelement in Form von Federn 4 oder von feststehenden Magneten 14 auf. Bei einer Auslenkung des Magneten 3 aus seiner Ruhelage dienen die Rückstellelemente dazu, eine Rückstellkraft auf den Magneten 3 in Richtung seiner Ruhelage auszuüben. Die Stärke der Rückstellkraft ist proportional zur Auslenkung des Magneten 3 aus seiner Ruhelage. Bei einer externen Krafteinwirkung auf das Schwingungssystem, wie insbesondere bei einer vom Fahrzeug verursachten Vibration, wird der Magnet 3 jeweils trägheitsbedingt aus seiner Ruhelage ausgelenkt und gerät aufgrund der Rückstellelemente in eine Schwingungsbewegung.

Auf der in der Ansicht der Figur 1 linken Seite des Lichtleiters 12 sind nebeneinander zwei Schwingungssysteme mit jeweils einem beweglichen Magneten 3 und entsprechenden Rückstellelementen zum Halten des Magneten 3 angeordnet. Bei den Rückstellelementen handelt es sich bei beiden Schwingungssystemen jeweils um zwei Federn 4, die als Schraubenfedern ausgebildet sind. Die erste dieser Federn 4 ist mit ihrem ersten Ende am Magneten 3 angebracht und mit ihrem zweiten Ende an der Abdeckung 11. Die zweite Feder 4 ist mit ihrem ersten Ende am Magneten 3 angebracht und mit ihrem zweiten Ende an der Trägerplatte 7. Der von den beiden Federn 4 gehaltene Magnet 3 kann somit jeweils in vertikaler Richtung zwischen der Abdeckung 11 und der Trägerplatte 7 hin- und herschwingen.

Auf der in der Ansicht der Figur 1 rechten Seite des Lichtleiters 12 ist ein drittes Schwingungssystem mit einem beweglichen Magneten 3 vorgesehen. Dieses dritte Schwingungssystem umfasst als Rückstellelemente zwei feststehende Magnete 14. Die beiden feststehenden Magnete 14 sind derart unbeweglich im Innenraum 18 der Zierleiste an einer Spulen- und Magnethalterung 15 befestigt, dass sie eine magnetische Rückstellkraft auf den dazwischen angeordneten Magneten 3 ausüben können. Da die beiden Magnete 14 beide auf derselben Höhe zwischen der Trägerplatte 7 und der Abdeckung 11 im Innenraum 18 angeordnet sind, kann der bewegliche Magnet 3 in einer horizontalen Richtung zwischen den beiden feststehenden Magneten 14 hin- und herschwingen. Der bewegliche Magnet 3 ist dabei bzgl. seiner Bewegung von der Spulen- und Magnethalterung 15 geführt.

Dadurch, dass die Ausführungsform der Figur 1 sowohl in die horizontale als auch in die vertikale Richtung ausgerichtete Schwingungssysteme aufweist, kann unabhängig von der Richtung der Fahrzeugvibrationen ein elektrischer Strom generiert werden.

Um die Bewegungsenergie des Magneten 3 während des Hin- und Herschwingens in einen elektrischen Strom umzuwandeln, weisen alle Schwingungssysteme jeweils zumindest eine Induktionseinheit auf. Eine Induktionseinheit umfasst jeweils einen Spulenkörper 2 mit mehreren Windungen. Die Spulenkörper 2 sind derart angeordnet, dass während der Schwingungsbewegung des Magneten 3 in deren Windungen mittels elektromagnetischer Induktion ein elektrischer Strom generiert wird. Der Magnet 3 ist hierzu üblicherweise als ein Permanentmagnet ausgestaltet. Zum Einstellen der Resonanzfrequenz des Schwingungssystems sind die Windungen der Spulenkörper 2 jeweils einzeln zu- bzw. abschaltbar.

Der in den Spulenkörpern 2 induzierte elektrische Strom wird zu einem UltraCap 10 geleitet. Der UltraCap 10 weist eine flache Bauform auf und ist zwischen der Trägerplatte 7 und dem Lichtleiter 12 angeordnet. Er dient als Energiespeicher dazu, den in den Spulenkörpern 2 induzierten Strom zu speichern, so dass auch nach einem Stillstand des Fahrzeugs weiterhin elektrische Energie zur Verfügung steht.

Die in der Figur 1 gezeigte Zierleiste weist zudem einen im Innenraum 18 angeordneten Beschleunigungssensor 17 auf. Der Beschleunigungssensor 17 dient zur Ermittlung der Vibrationsfrequenzen des Fahrzeugs. Die vom Beschleunigungssensor 17 erfassten Beschleunigungsdaten werden dazu an ein Elektronikbauteil 8 geleitet, in welchem eine Frequenzanalyse durchgeführt und die aktuellen Vibrationsfrequenzen des Fahrzeugs ermittelt werden. Je nach Höhe der ermittelten Vibrationsfrequenzen werden vom Elektronikbauteil 8, bei welchem es sich um eine Steuereinheit handelt, mehr oder weniger Windungen der Spulenkörper 2 zu- bzw. abgeschaltet. Je nach Anzahl der während der Schwingungsbewegung des Magneten 3 zugeschalteten Windungen der Spulenkörper 2 wird aufgrund der Lenzschen Regel eine höhere oder tiefere Resonanzfrequenz des Schwingungssystems bewirkt. Mit Hilfe des Beschleunigungssensors 17 und dem Zuschalten von mehr oder weniger Windungen der Spulenkörper 2 kann die Resonanzfrequenz der in der Zierleiste vorgesehenen Schwingungssysteme somit vom Elektronikbauteil 8 an eine aktuelle Vibrationsfrequenz des Fahrzeugs angepasst werden. Die Stromerzeugung kann dadurch automatisch an den Fahrzeugtyp, die Bereifung, den Fahrbahnzustand (Asphalt, Kiesweg, Schnee etc.), den Ladezustand etc. angepasst werden.

Im Gegensatz zu der in der Figur 1 gezeigten Ausführungsform sind bei den Ausführungsformen der Figuren 2 und 3 jeweils nur zwei Schwingungssysteme vorhanden, welche jeweils einen in horizontaler Richtung beweglichen Magneten 3 umfassen. Der Magnet 3 ist zwischen zwei Schraubenfedern 4 angeordnet und wird von jeweils einem Ende dieser Federn 4 gehalten. Mit ihrem anderen Ende sind die Federn 4 jeweils an einer im Innenraum 18 feststehenden Federhalterung 1 angebracht. Während die federbasierten Schwingungssysteme bei der in der Figur 2 gezeigten Ausführungsform beide auf derselben Seite des Lichtleiters 12 angeordnet sind, ist bei der in der Figur 3 gezeigten Ausführungsform beidseitig neben dem Lichtleiter 12 jeweils ein horizontales, federbasiertes Schwingungssystem vorgesehen.

Die in der Figur 4 gezeigte Ausführungsform unterscheidet sich dadurch von der Ausführungsform der Figur 1, dass anstelle der beiden vertikalen, federbasierten Schwingungssysteme ein einzelnes horizontales, magnetbasiertes Schwingungssystem vorgesehen ist. Auf beiden Seiten des Lichtleiters 12 sind hier somit identisch ausgebildete Schwingungssysteme mit jeweils einem Magneten 3 angeordnet, der zwischen zwei feststehenden Magneten 14 beweglich und dabei von entsprechenden Spulenkörpern 2 umgeben ist.

Während die beiden horizontalen, magnetbasierten Schwingungssysteme bei der Ausführungsform der Figur 4 beidseitig neben dem Lichtleiter 12 angeordnet sind, sind sie bei der in der Figur 5 gezeigten Ausführungsform einseitig neben dem Lichtleiter 12 angeordnet.

Die Figur 6 zeigt eine weitere Ausführungsform, bei welcher die Schwungmassen, d.h. die Magnete 3, während des Schwingungszustandes jeweils nicht translatorisch hin- und herschwingen, sondern eine Rotationsbewegung durchführen (Rotationsrichtung 16). Die Magnete 3 weisen hierzu jeweils die Form einer Scheibe auf, welche flach in der horizontalen Ebene der Zierleiste 3 liegt. Die Magnete 3 sind dabei jeweils mit einer in der Figur 6 nicht erkennbaren Torsionsfeder verbunden, welche hier als Rückstellelement dient. Ein Spulenkörper 2 umgibt auch hier den Magneten 3 zumindest teilweise, so dass bei einer Bewegung des Magneten 3 ein elektrischer Strom in den Spulenkörper 2 induziert wird.

Die in der Figur 6 gezeigte Ausführungsform weist zusätzlich einen Lichtsensor 19 auf, um den Öffnungszustand der Türe zu detektieren und in Abhängigkeit davon das Leuchtelement 9 ein- bzw. auszuschalten. Die Verwendung eines Lichtsensors 19 ist insbesondere vorteilhaft, wenn es sich bei der stromerzeugenden Vorrichtung um eine Einstiegsleiste handelt. Der Lichtsensor 19, welcher üblicherweise mit dem Elektronikbauteil 8 verbunden ist, könnte selbstverständlich auch bei den in den Figuren 1 bis 5 gezeigten Ausführungsformen vorgesehen sein.

In der Figur 7 sind die x-, y- und z-Achsen eines Fahrzeugs illustriert, wobei der Ursprung des durch die x-, y- und z-Achse gebildeten Koordinatensystems innerhalb der stromerzeugenden Vorrichtung angeordnet ist. Die Längsachse 20 des Fahrzeugs erstreckt sich parallel zur x-Achse entlang der Fahrtrichtung. Die in den Figuren 1 bis 5 gezeigten Schwungmassen 3 der horizontal ausgerichteten Schwingungssysteme sind bevorzugt jeweils entlang der x-Achse bewegbar.

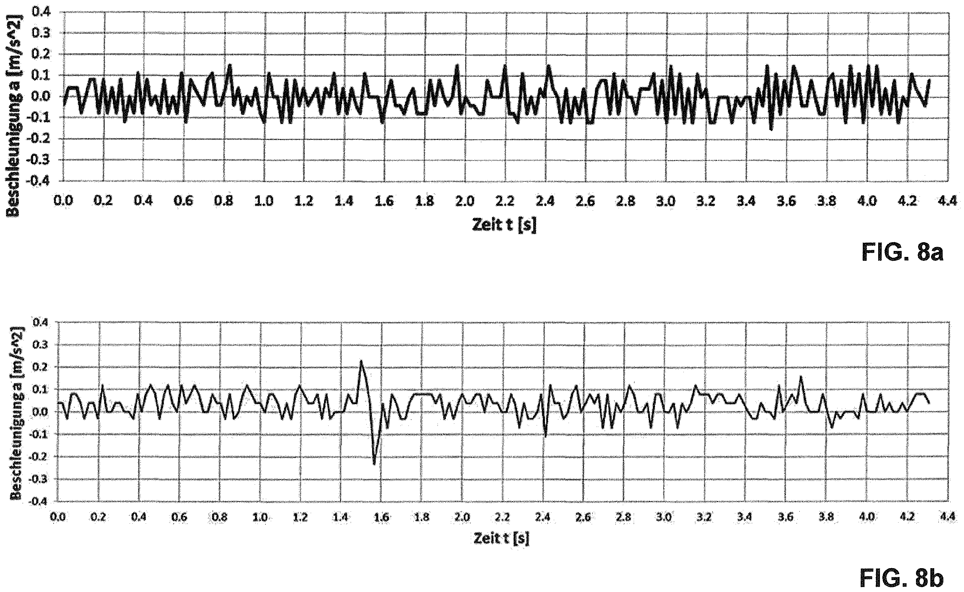

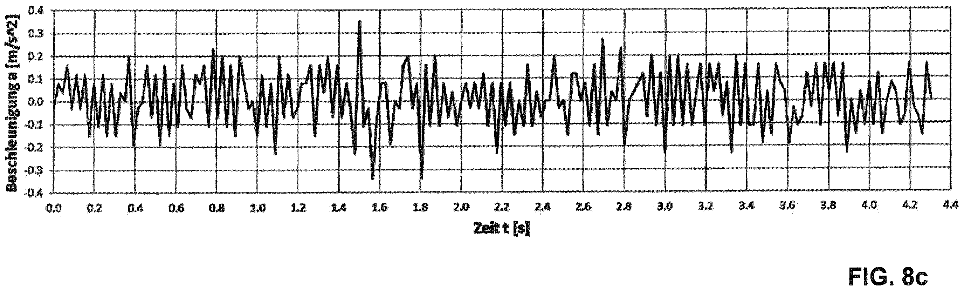

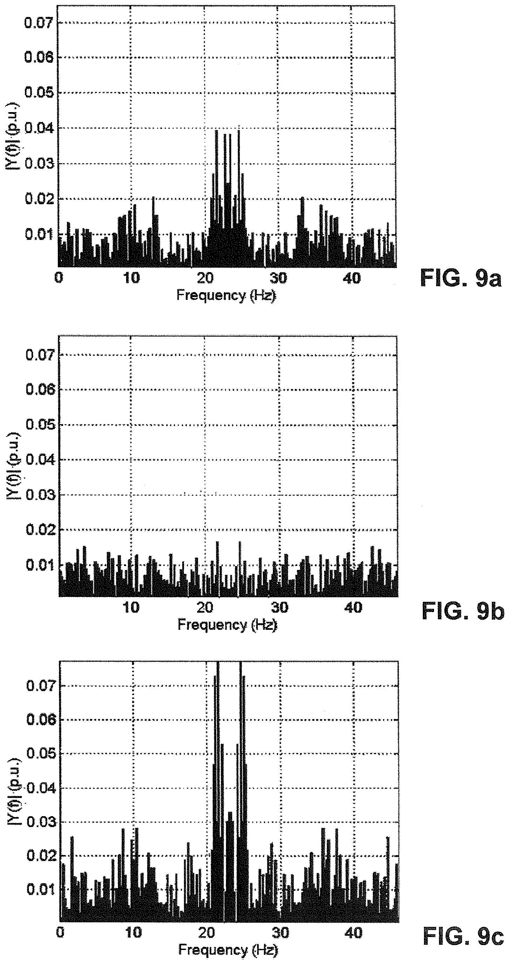

Die Figuren 8a, 8b sowie 8c zeigen die vom Beschleunigungssensor 17 in einem Versuch über einen gewissen Zeitraum ermittelten Beschleunigungsdaten eines Fahrzeugs. Bezugnehmend auf die Figur 7 ist in der Figur 8a die x-Komponente, in der Figur 8b die y-Komponente und in der Figur 8c die z-Komponente der von den Fahrzeugvibrationen hervorgerufenen Beschleunigung dargestellt. Die Figuren 9a, 9b und 9c zeigen die entsprechenden Spektren im Frequenzraum. Die Umwandlung der Daten vom Zeitraum in den Frequenzraum und umgekehrt wird mittels einer Fourier-Transformation erreicht, welche insbesondere vom Elektronikbauteil 8 durchgeführt werden kann. Die Fourier-Transformation ist dem Fachmann hinlänglich bekannt. Basierend auf diesen Spektren werden im Elektronikbauteil 8 eine oder mehrere Frequenzen, insbesondere Maximalfrequenzen, ausgewählt, an welche dann die jeweilige Resonanzfrequenz der in den Figuren 1-6 gezeigten Schwingungssysteme 3, 4 bzw. 3, 14 angepasst wird.

Die vorliegende Erfindung ist natürlich nicht auf die vorstehenden Ausführungsformen beschränkt, sondern eine Vielzahl von Abwandlungen ist möglich. So muss die Vorrichtung zum Beispiel nicht zwingend einen Lichtleiter 12 aufweisen. Es könnte beispielsweise auch ein Leuchtelement hinter jedem der Durchbrüche 13 angeordnet sein. Die Spulenkörper 2 müssen nicht unbedingt derart angeordnet sein, dass die beweglichen Magnete 3 bei ihrer Schwingungsbewegung von diesen zumindest teilweise umgeben werden. Die Magnete 3 könnten sich während der Schwingung zum Beispiel auch senkrecht zu den Längsrichtungen der Spulenkörper vor diesen hin- und her bewegen. Anstelle eines Spulenkörpers könnte auch einer oder mehrere gerade Drähte verwendet werden, in welche bei der Schwingungsbewegung ein elektrischer Strom induziert wird. Anstatt in einer Zierleiste könnte die stromerzeugende Einrichtung mit dem Schwingungssystem und der Induktionseinheit in einem beliebigen anderen Fahrzeugbereich verwendet werden und zum Beispiel zur Innen- oder Kofferraumbeleuchtung, zur Beleuchtung des Armaturenbretts oder des Fahrzeugkennzeichens etc. verwendet werden. Eine Vielzahl weiterer Abwandlungen ist möglich.

**BEZUGSZEICHENLISTE**

| | | | |
|---|---|---|---|
| 1 | Federhalterung | 11 | Abdeckung |
| 2 | Spulenkörper | 12 | Lichtleiter |
| 3 | Magnet (beweglich) | 13 | Durchbruch |
| 4 | Feder | 14 | Magnet (fixiert) |
| 5 | Bewegungsrichtung | 15 | Spulen- und Magnethalterung |
| 6 | Freiraum | 16 | Rotationsrichtung |
| 7 | Trägerplatte | 17 | Beschleunigungssensor |
| 8 | Elektronikbauteil | 18 | Innenraum |
| 9 | Leuchtelement | 19 | Lichtsensor |
| 10 | UltraCap | 20 | Längsachse |

## Patentansprüche

1. Fahrzeug mit einer stromerzeugenden Vorrichtung aufweisend
ein Schwingungssystem (3, 4; 3, 14) mit einer beweglich angeordneten Schwungmasse (3); sowie
eine Induktionseinheit (2) zur induktiven Umwandlung von Bewegungsenergie der Schwungmasse (3) in elektrische Energie;
**dadurch gekennzeichnet, dass**
die stromerzeugende Vorrichtung zudem zumindest einen Sensor (17) zur Ermittlung einer Vibrationsfrequenz des Fahrzeugs sowie eine Steuereinheit (8) zur Anpassung der Resonanzfrequenz des Schwingungssystems (3, 4; 3, 14) an eine ermittelte Vibrationsfrequenz des Fahrzeugs aufweist, und dass das Schwingungssystem (3, 4; 3, 14), was im Schwingungszustand die Bewegungsrichtung der Schwungmasse (3) angeht, im Wesentlichen parallel zur Längsachse des Fahrzeugs angeordnet ist.

2. Fahrzeug nach Anspruch 1 wobei es sich beim Sensor um einen Beschleunigungssensor (17) handelt.

3. Fahrzeug nach Anspruch 1 oder 2, wobei die Induktionseinheit (2) zumindest eine Induktionsspule (2) mit einer Vielzahl von Windungen aufweist, wobei zur Anpassung der Resonanzfrequenz des Schwingungssystems (3, 4; 3, 14) wenigstens eine Windung zu- bzw. abschaltbar ist.

4. Fahrzeug nach einem der vorangehenden Ansprüche, aufweisend ein Gehäuse (7, 11) mit einem Innenraum (18), innerhalb welchem das Schwingungssystem (3, 4; 3, 14), die Induktionseinheit (2) und der Sensor (17) angeordnet sind.

5. Fahrzeug nach einem der vorhergehenden Ansprüche, wobei es sich bei der stromerzeugenden Vorrichtung um eine hinterleuchtbare Zierleiste handelt.

6. Fahrzeug nach Anspruch 5, wobei die Zierleiste einen Innenraum (18) aufweist, in welchem das Schwingungssystem (3, 4; 3, 14), die Induktionseinheit (2) und der Sensor (17) sowie zumindest ein Leuchtelement (9) angeordnet sind.

7. Fahrzeug nach Anspruch 6, wobei der Innenraum (18) nach aussen hin von einer Abdeckung (11) abgedeckt ist, welche vom Leuchtelement (9) durchleuchtbar ist, insbesondere hinterleuchtbare Durchbrüche (13), aufweist.

8. Fahrzeug nach einem der Ansprüche 5 bis 7, welche zum Hinterleuchten ein Leuchtelement (9) aufweist, und welche zudem einen Lichtsensor (19) aufweist, um den Öffnungszustand einer Fahrzeugtüre zu detektieren und in Abhängigkeit vom detektierten Öffnungszustand der Fahrzeugtüre das Leuchtelement (9) ein- bzw. auszuschalten.

9. Fahrzeug nach einem der vorhergehenden Ansprüche, wobei die Resonanzfrequenz des Schwingungssystems (3, 4; 3, 14) im Bereich von 15 bis 80 Hz liegt.

10. Fahrzeug nach einem der vorhergehenden Ansprüche, wobei die Vorrichtung zumindest eine Feder (4) aufweist, um als Rückstellelement bei einer Bewegung der Schwungmasse (3) aus ihrer Ruhelage heraus auf die Schwungmasse (3) eine Rückstellkraft in Richtung der Ruhelage auszuüben.

11. Fahrzeug nach einem der vorhergehenden Ansprüche, wobei die Vorrichtung zumindest einen Magneten (14) aufweist, um als Rückstellelement bei einer Bewegung der Schwungmasse (3) aus ihrer Ruhelage heraus auf die Schwungmasse (3) eine Rückstellkraft in Richtung der Ruhelage auszuüben.

12. Fahrzeug nach einem der vorhergehenden Ansprüche, ausserdem aufweisend einen Energiespeicher, insbesondere einen Kondensator-Speicher (10), zur Speicherung der von der Induktionseinheit (2) erzeugten elektrischen Energie.

13. Fahrzeug nach einem der vorhergehenden Ansprüche, wobei die Schwungmasse (3) einen Permanentmagneten aufweist.

14. Fahrzeug nach einem der vorhergehenden Ansprüche, wobei die stromerzeugende Vorrichtung fest mit der Karosserie des Fahrzeugs verbunden ist.

## Claims

1. A vehicle with an electric power generating device, having
an oscillation system (3, 4; 3, 14) having a movably disposed inertial mass (3); and
an induction unit (2) for inductively converting kinetic energy of the inertial mass (3) into electrical energy;
**characterized in that**
the electric power generating device additionally has at least one sensor (17) for determining an oscillation frequency of the vehicle, and a control unit (8) for adjusting the resonant frequency of the oscillation system (3, 4; 3, 14) to a determined oscillation frequency of the vehicle, and **in that** the oscillation system (3, 4; 3, 14), with regard to the direction of motion of the inertial mass (3) when in the oscillating state, is disposed substantially parallel to the longitudinal axis of the vehicle.

2. The vehicle as claimed in claim 1, wherein the sensor is an acceleration sensor (17).

3. The vehicle as claimed in claim 1 or 2, wherein the induction unit (2) has at least one induction coil (2) having a multiplicity of windings, wherein at least one winding can be switched into and out of circuit for the purpose of adjusting the resonant frequency of the oscillation system (3, 4; 3, 14).

4. The vehicle as claimed in any one of the preceding claims, having a housing (7, 11), having an interior (18) within which the oscillation system (3, 4; 3, 14), the induction unit (2) and the sensor (17) are disposed.

5. The vehicle as claimed in any one of the preceding claims, wherein the electric power generating device is a backlightable trim strip.

6. The vehicle as claimed in claim 5, wherein the trim strip has an interior (18), in which the oscillation system (3, 4; 3, 14), the induction unit (2) and the sensor (17), and at least one lighting element (9), are disposed.

7. The vehicle as claimed in claim 6, wherein the interior (18) is covered outwardly by a cover (11) that is translucent to the lighting element (9), in particular has backlightable through-holes (13).

8. The vehicle as claimed in any one claims 5 to 7, which has a lighting element (9) for the purpose of backlighting, and which additionally has a light sensor (19), in order to detect the opening state of a vehicle door and to switch the lighting element (9) on or off in dependence on the detected opening state of the vehicle door.

9. The vehicle as claimed in any one of the preceding claims, wherein the resonant frequency of the oscillation system (3, 4; 3, 14) is in the range of from 15 to 80 Hz.

10. The vehicle as claimed in any one of the preceding claims, wherein the device has at least one spring (4) in order, upon the inertial mass (3) moving out of its neutral position, to exert, as a restoring element, a restoring force on the inertial mass (3), in the direction of the neutral position.

11. The vehicle as claimed in any one of the preceding claims, wherein the device has at least one magnet (14) in order, upon the inertial mass (3) moving out of its neutral position, to exert, as a restoring element, a restoring force on the inertial mass (3), in the direction of the neutral position.

12. The vehicle as claimed in any one of the preceding claims, additionally having an energy storage, in particular a capacitor storage (10), for storing the electrical energy generated by the induction unit (2).

13. The vehicle as claimed in any one of the preceding claims, wherein the inertial mass (3) has a permanent magnet.

14. The vehicle as claimed in one of the preceeding claims, wherein the electric power generating device is fixedly connected to the body of the vehicle.

## Revendications

1. Un véhicule automobile ayant un dispositif générateur d'électricité, comprenant
un système oscillatoire (3, 4; 3, 14) présentant une masse d'inertie (3) disposée de manière mobile, ainsi qu'
une unité d'induction (2) pour la conversion inductive de l'énergie cinétique de la masse d'inertie (3) en énergie électrique ;
**caractérisé en ce que**
le dispositif générateur d'électricité en outre présente un capteur (17) pour déterminer une fréquence oscillatoire du véhicule ainsi qu'une unité de commande (8) pour adapter une fréquence de résonance du système oscillatoire (3, 4; 3, 14) à une fréquence oscillatoire déterminée du véhicule, et que le système oscillatoire (3, 4; 3, 14), en ce qui concerne la direction de mouvement de la masse d'inertie (3) dans un état d'oscillation, est disposé sensiblement en parallèle à l'axe longitudinal du véhicule automobile.

2. Le véhicule selon la revendication 1, où dans le cas du capteur, il s'agit d'un capteur d'accélération (17).

3. Le véhicule selon la revendication 1 ou 2, où l'unité d'induction présente au moins une bobine d'induction (2) ayant une pluralité de spires, où au moins une spire peut être branchée respectivement débranchée pour adapter la fréquence de résonance du système oscillatoire (3, 4; 3, 14).

4. Le véhicule automobile selon une des revendications précédentes, présentant un boîtier (7, 11) ayant un espace intérieur (18), à l'intérieur duquel le système oscillatoire (3, 4, 3, 14), l'unité d'induction (2) et le capteur (17) sont disposés.

5. Le véhicule automobile selon une des revendications précédentes, où dans le cas du dispositif générateur d'électricité, il s'agit d'un bandeau décoratif pouvant être rétroéclairé.

6. Le véhicule automobile selon la revendication 5, où le bandeau décoratif présente un espace intérieur (18), dans lequel le système oscillatoire (3, 4, 3, 14), l'unité d'induction (2) et le capteur (17) ainsi que au moins un élément d'éclairage (9) sont disposés.

7. Le véhicule automobile selon la revendication 6, dans lequel l'espace intérieur (18) est recouvert vers l'extérieur par un recouvrement (11), lequel peut être illuminé par l'élément d'éclairage (9), en particulier présente des percées (13) pouvant être rétroéclairées.

8. Le véhicule automobile selon une des revendications 5 à 7, lequel présente un élément d'éclairage (9) pour le rétroéclairage, et lequel présente en outre un capteur de lumière (19) servant à détecter l'état d'ouverture d'une porte de véhicule automobile et servant à allumer ou respectivement éteindre l'élément d'éclairage (9) en dépendance de l'état d'ouverture de la porte de véhicule automobile détecté.

9. Le véhicule automobile selon une des revendications précédentes, où la fréquence de résonance du système oscillatoire (3, 4, 3, 14) se situe dans la plage de 15 à 80 Hz.

10. Le véhicule automobile selon une des revendications précédentes, où le dispositif présente au moins un ressort (4) pour exercer une force de rappel en direction de l'état de repos sur la masse d'inertie (3) en tant qu'élément de rappel lors d'un mouvement de la masse d'inertie (3) en dehors de son état de repos.

11. Le véhicule automobile selon une des revendications précédentes, où le dispositif présente au moins un aimant (14) pour exercer une force de rappel en direction de l'état de repos sur la masse d'inertie (3) en tant qu'élément de rappel lors d'un mouvement de la masse d'inertie (3) en dehors de son état de repos.

12. Le véhicule automobile selon une des revendications précédentes, présentant en outre un réservoir d'énergie, en particulier un réservoir à condensateur (10), pour le stockage d'énergie électrique générée par l'unité d'induction (2).

13. Le véhicule automobile selon une des revendications précédentes, où la masse d'inertie (3) présente un aimant permanent.

14. Le véhicule automobile selon une des revendications précédentes, où le dispositif générateur d'électricité est relié de manière fixe à la carrosserie du véhicule automobile.
